Europäisches Patentamt

European Patent Office

Office européen des brevets

(11) Numéro de publication: **0 325 499 B1**

## FASCICULE DE BREVET EUROPEEN

(45) Date de publication de fascicule du brevet: **20.04.94**  (51) Int. Cl.⁵: **H03M 1/18**, H03M 1/00

(21) Numéro de dépôt: **89400029.8**

(22) Date de dépôt: **05.01.89**

(54) Dispositif d'acquisition pour la numérisation de signaux à grande dynamique.

(30) Priorité: **21.01.88 FR 8800764**

(43) Date de publication de la demande:
**26.07.89 Bulletin  89/30**

(45) Mention de la délivrance du brevet:
**20.04.94 Bulletin  94/16**

(84) Etats contractants désignés:
**DE GB IT NL**

(56) Documents cités:
**FR-A- 1 481 960**
**FR-A- 2 580 877**
**US-A- 3 411 153**
**US-A- 3 585 631**
**US-A- 3 699 325**

**PATENT ABSTRACTS OF JAPAN, vol. 6, no.**
**254 (E-148)[1132], 14 décembre 1982, page 54**
**E 148; & JP-A-57 152 726 (TOKYO SHIBAURA**
**DENKI K.K.) 21-09-1982**

(73) Titulaire: **INSTITUT FRANCAIS DU PETROLE**
**4, Avenue de Bois Préau**
**F-92506 Rueil-Malmaison Cédex(FR)**

(72) Inventeur: **Beauducel, Claude**
**8, rue Talon**
**F-60119 Henonville(FR)**

## Description

La présente invention a pour objet un dispositif d'acquisition permettant de numériser des signaux à grande dynamique après une amplification éventuelle.

L'acquisition de signaux analogiques à grande dynamique intervient dans de nombreux domaines et notamment dans le domaine de la prospection sismique.

Les méthodes de prospection sismique comportent généralement l'émission d'ondes par une source sismique, la réception des ondes renvoyées par les différents interfaces réfléchissants du sous-sol et la réalisation d'enregistrements sismiques représentatifs de la configuration du sous-sol. La réception des ondes est effectuée par des dispositifs de réception comportant un très grand nombre de capteurs répartis le long du profil sismique à étudier. Pour la prospection sismique en mer, les capteurs sont répartis tout le long et à l'intérieur d'une gaine souple, étanche, de grande longueur que l'on appelle flûte sismique.

L'ensemble des capteurs est généralement réparti en une pluralité de sous-ensembles. Les signaux captés par les capteurs d'un même sous-ensemble sont le plus souvent collectés par un appareil électronique d'acquisition de données qui les numérise et les enregistre. A intervalles déterminés, les signaux enregistrés par les différents appareils d'acquisition sont transmis séquentiellement à un laboratoire central de commande et d'enregistrement par l'intermédiaire d'un système de transmission multiplexée au moyen de lignes de transmission ou encore par radio. Un tel système de transmission est décrit par exemple dans le brevet FR-A-2 471 088.

Pour obtenir un pouvoir de résolution de plus en plus grand, on est conduit à développer des dispositifs de réception sismique, comportant un nombre accru de capteurs sismiques et par conséquent à augmenter parallèlement le nombre et la complexité des appareils d'acquisition utilisés pour collecter tous les signaux reçus. Il est donc souhaitable d'employer des appareils d'acquisition dont les différents modules électroniques sont optimisés pour concilier à la fois les performances, la fiabilité et une consommation électrique relativement basse.

Les dispositifs d'acquisition utilisés notamment dans les systèmes d'émission-réception sismiques, comportent par exemple un multiplexeur analogique dont les différentes entrées sont connectées aux différents capteurs de signaux, soit directement, soit par l'intermédiaire de préamplificateurs à gain fixe et de filtres. La sortie du multiplexeur est connectée à un amplificateur unique constitué de plusieurs étages connectés en série ou en parallèle. Chacun des étages peut être associé à un réseau de contre-réaction. Un organe de sélection choisit le nombre d'étages d'amplification et/ou leurs gains respectifs, de manière à donner à chaque signal amplifié une amplitude convenable avant de l'appliquer à un convertisseur analogique-numérique. Celui-ci transforme chaque échantillon de signal en un mot numérique, en comparant son amplitude avec un signal de référence fixe qui lui est appliqué.

Différents amplificateurs sont décrits par exemple dans le brevet FR-A-2 234 709 où les brevets US-A-4 069 479, 4 031 504, 3 754 240 etc. L'application à un signal d'un gain ou d'une atténuation optimale, exige le plus souvent de réaliser des commutations pour faire varier le nombre d'étages qu'il traverse et/ou le gain ou l'atténuation appliqué par chacun d'eux et l'on est confronté alors à des difficultés de mise au point tenant aux tensions dites "d'offset" aux non-linéarités des étages, aux risques de saturation, ces difficultés étant d'autant plus grandes que l'on utilise des étages d'amplification aux performances limitées, ceci pour des raisons de prix de revient ou de consommation électrique notamment.

Le dispositif d'acquisition selon l'invention permet de transformer un signal analogique en échantillons de signaux numérisés avec une structure relativement simple où les signaux appliqués ne sont pratiquement pas altérés durant toute la phase de leur acquisition.

Le dispositif d'acquisition selon l'invention est défini dans la revendication 1.

Le moyen diviseur de la tension stabilisée comporte par exemple un réseau de résistances dont les valeurs sont choisies pour que les tensions secondaires soient dans un rapport de proportionnalité déterminé les unes par rapport aux autres.

Avec une telle structure, les signaux à numériser, préalablement amplifiés s'il y a lieu dans un amplificateur à gain fixe, sont directement appliqués aux moyens d'échantillonnage et de conversion analogique-numérique.

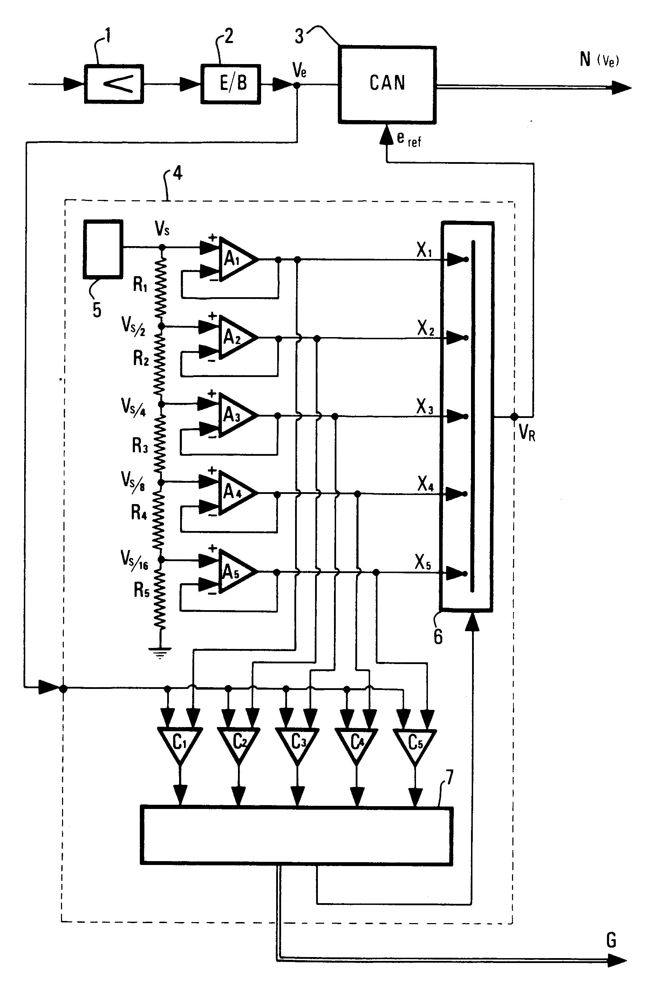

D'autres caractéristiques et avantages du dispositif selon l'invention apparaîtront à la lecture de la description d'un mode de réalisation donné à titre d'exemple non limitatif, en se référant au dessin annexé où la figure 1 montre un schéma synoptique du dispositif.

On voit sur la figure 1 que les signaux à numériser sont appliqués à un amplificateur à gain fixe 1 si leur niveau est insuffisant. Les signaux amplifiés sont dirigés vers l'entrée d'un échantillonneur-bloqueur 2. La sortie de celui-ci est connectée à l'entrée d'un convertisseur analogique-numérique 3. Le dispositif comporte un ensemble 4 pour engendrer une tension de référence variable. Cet ensemble 4 comporte une source de tension stabilisée 5 délivrant une tension bien constante $V_S$. Un réseau diviseur de tension comportant par exemple cing résistances $R_1$ à $R_5$ interconnectées en série, relie à la masse la sortie de la source de tension 5. Les valeurs des différentes résistances $R_1$ à $R_5$ du réseau sont choisies de manière que les tensions mesurables aux noeuds d'interconnexion des résistances $R_1$ et $R_2$, $R_2$ et $R_3$, $R_3$ et $R_4$, $R_4$ et $R_5$, soient respectivement égales à $V_S/2$, $V_S/4$, $V_S/8$ et $V_S/16$ par exemple. La sortie de la source 5 et les différents noeuds d'interconnexion sont reliés respectivement aux entrées de cing amplificateurs-tampons $A_1$, , $A_2...A_5$. Les sorties de ces amplificateurs-tampons sont connectées à cinq entrées $X_1$ , $X_2...X_5$ d'un multiplexeur 6. La sortie de celui-ci est connectée à l'entrée $e_{ref}$ du convertisseur analogique-numérique 3 adaptée à recevoir la tension de référence en fonction de laquelle la conversion en signaux numériques est effectuée.

Les sorties des amplificateurs-tampons $A_1$ à $A_5$ sont respectivement connectées aussi à une première entrée de cinq comparateurs de tensions $C_1$, $C_2...C_5$. La seconde entrée de chacun de ceux-ci est reliée à la sortie de l'échantillonneur-bloqueur 2.

Les sorties de comparateurs $C_1$ à $C_5$ sont connectées à des entrées d'un ensemble de portes logiques 7 adapté à sélectionner la tension $V_R$ à appliquer sur l'entrée $e_{ref}$ du convertisseur 3 parmi les tensions disponibles aux entrées $X_1$ à $X_5$ du multiplexeur 6, et à délivrer un signal indicatif de la valeur G du gain à associer à chaque mot numérique N(Ve) issu du convertisseur analogique-numérique 3.

Les opérations de sélection peuvent être résumées par le tableau ci-dessous où la première colonne P correspond aux différentes plages de variation de la tension $V_e$, délimitées par les tensions $V_S$, $V_S/2$, $V_S/4$, $V_S/8$ et $V_S/16$; la seconde colonne X, au numéro d'une entrée $X_1$ à $X_5$ du multiplexeur 6 effectivement connectée à l'entrée $e_{ref}$ du convertisseur analogique-numérique 3 en fonction de la plage où se situe la tension d'entrée $V_e$ et la troisième colonne, le mot numérique G à 3 bits associé à chaque valeur numérique N(Ve) en fonction de la commutation effectuée par le multiplexeur 6.

| P | X | G | | |
|---|---|---|---|---|
| | | $g_0$ | $g_1$ | $g_2$ |
| $\dfrac{V_S}{2} < V_e < V_S$ | $X_1$ | 0 | 0 | 0 |
| $\dfrac{V_S}{4} < V_e < \dfrac{V_S}{2}$ | $X_2$ | 1 | 0 | 0 |
| $\dfrac{V_S}{8} < V_e < \dfrac{V_S}{4}$ | $X_3$ | 0 | 1 | 0 |
| $\dfrac{V_S}{16} < V_e < \dfrac{V_S}{8}$ | $X_4$ | 1 | 1 | 0 |
| $V_e < \dfrac{V_S}{16}$ | $X_5$ | 0 | 0 | 1 |

Chaque échantillon de signal numérisé est donc defini par deux mots numériques l'un N(Ve) correspondant à une mantisse et l'autre G à un exposant associé. Le convertisseur-analogique numérique 3 et les différents circuits de sélection de la tension de référence permettent donc de numériser des signaux à dynamique très large.

On ne sortirait pas du cadre de l'invention en changeant le nombre de plages de variations aux limites desquelles on opère des changements de la tension de référence appliquée au convertisseur analogique-numérique, ou bien en choisissant des coefficients de proportionnalité quelconques entre les tensions disponibles sur le réseau diviseur de tension ($R_1$ à $R_5$) au lieu des puissances successives de 2.

# EP 0 325 499 B1

## Revendications

**1.** Dispositif d'acquisition pour échantillonner et numériser des signaux à grande dynamique comportant la combinaison de moyens (2) d'échantillonnage des signaux, d'un convertisseur analogique-numérique (3), adapté à transformer les échantillons de signal délivrés successivement par les moyens d'échantillonnage (2) en mots numériques, par comparaison de l'amplitude desdits échantillons avec une tension de référence et de moyens de sélection (4) pour engendrer une tension de référence stabilisée ($e_{ref}$) pour ledit convertisseur (3), dont l'amplitude dépend de l'amplitude des signaux à numériser, caractérisé en ce que lesdits moyens de sélection (4) comportent un générateur (5) produisant une tension continue stabilisée d'amplitude fixe, un moyen diviseur de tension unique (R1 - R5) produisant une pluralité de tensions secondaires fixes et une unité de sélection unique comportant plusieurs comparateurs de tension, pour comparer l'amplitude de chacun des échantillons successifs avec ladite pluralité de tensions secondaires dérivées de la tension stabilisée, un moyen de commutation (6), pour choisir l'une des tensions secondaires et un ensemble logique (7), unique, pour engendrer un signal de commande du moyen de commutation de façon à choisir parmi les tensions secondaires, celle qui convient pour la numérisation de chacun des échantillons de signaux successifs à numériser, et un signal indicatif de ladite tension secondaire choisie et des moyens de connexion pour appliquer ladite tension secondaire choisie à l'entrée du convertisseur (3) destinée à l'application d'une tension de référence, ledit ensemble logique (7) étant adapté à produire un mot numérique qui, avec celui issu du convertisseur analogique-numérique (3) représente la valeur numérisée des échantillons de signaux issus des moyens d'échantillonnage (2).

**2.** Dispositif d'acquisition selon la revendication 1, dans lequel le moyen diviseur de la tension stabilisée comporte un réseau de résistances (R1 - R5) dont les valeurs sont choisies pour que les tensions secondaires soient dans un rapport de proportionnalité déterminé les unes par rapport aux autres.

**3.** Dispositif selon la revendication 1, dans lequel le moyen de commutation (6) est un multiplexeur.

## Claims

**1.** A collecting device for sampling and digitising highly dynamic signals having a combination of means (2) for sampling signals, an A-D convertor (3) adapted to transform signal samples issued successively by the sampling means (2) into digital words by comparing the amplitude of the samples against a reference voltage, and selection means (4) for generating a stabilized reference voltage ($e_{ref}$) for the convertor (3), whose amplitude depends on the amplitude of the signals to be digitised, characterised in that the selection means (4) have a generator (5) producing a continuous stabilized voltage of a fixed amplitude, a single voltage (R1 - R5) divider means producing a plurality of fixed secondary voltages and a single selection unit having several voltage comparators to compare the amplitude of each of the successive samples with the plurality of secondary voltages derived from the stabilized voltage, a switching means (6) to select one of the secondary voltages and a single logic assembly (7) to generate a command signal for the switching means so as to select from the secondary voltages the one that will be suitable for digitising each of the successive signal samples to be digitised and a signal indicative of the secondary voltage selected and connecting means to apply the selected secondary voltage to the input of the convertor (3) which will apply a reference voltage, the logic assembly (7) being adapted to produce a digital word which, with that issued by the A-D convertor (3) represents the digitised value of the signal samples emitted by the sampling means (2).

**2.** A collecting device in accordance with claim 1, in which the means for dividing the stabilized voltage has a network of resistors (R1 - R5) whose values are selected so that the secondary voltages are in a given ratio of proportionality to each other.

**3.** A device in accordance with claim 1, in which the switching means (6) is a multiplexer.

## Patentansprüche

**1.** Erfassungsvorrichtung zur Abtastung und Digitalisierung Von Signalen mit großer Dynamik, wobei diese die Kombination von Mitteln (2) zur Abtastung der Signale, von einem Analog-Digital Wandler (3), der an eine Umwandlung der, von den Abtast-Mitteln (2) sukzessive gelieferten Abtastungen der Signale in Datenworte durch Vergleich der Amplitude der Abtastungen mit einer Referenzspannung angepaßt ist, und von Auswahl-Mittel (4) umfaßt, um eine stabilisierte Referenzspannung $e_{ref}$ für den Wandler (3) zu erzeugen, dessen Amplitude von der Amplitude der zu digitalisierenden Signale abhängt, dadurch gekennzeichnet, daß

die Auswahl-Mittel (4) einen Generator (5), der eine ständig stabilisierte Spannung mit fester Amplitude erzeugt, ein einzelnes Spannungsteiler-Mittel (R1-R5), daß eine Mehrzahl fester sekundärer Spannungen erzeugt und eine einzelne Auswahleinheit, die mehrere Spannungswandler umfaßt, um die Amplitude jeder der sukzessiven Abtastungen mit der Mehrzahl sekundärer Spannungen, die von der stabilisierten Spannung stammen, zu vergleichen, ein Schaltungsmittel (6) zur Auswahl einer der sekundären Spannungen und eine einzelne Gesamtlogik (7) umfassen, um ein Steuersignal für das Schaltungsmittel zu erzeugen, um aus den sekundären Spannungen diejenige auszuwählen, die für die Digitalisierung jeder der Abtastungen der sukzessive zu digitalisierenden Signale paßt, und ein Signal diese sekundäre, auswählte Spannung anzeigt und Mittel zur Verbindung umfaßt, um die ausgewählte sekundäre Spannung, die für die Verwendung als Referenzspannung vorgesehen ist, an den Eingang des Wandlers (3) anzulegen, wobei die Gesamtlogik (7) darauf ausgelegt ist, ein digitales Wort zu erzeugen, daß mit dem, aus dem Analog-Digital Wandler (3) hervorgegangenen Wort, einen digitalen Wert für die, aus den Abtastmitteln (2) hervorgegangenen Abtastungen der Signale darstellt.

2. Erfassungsvorrichtung nach Anspruch 1, bei dem das Teiler-Mittel der stabilisierten Spannung ein Widerstands-Netzwerk (R1 - R5) umfaßt, dessen Werte so gewählt sind, daß die sekundären Spannungen in einem bestimmten zueinander proportionalen Verhältnis stehen.

3. Vorrichtung nach Anspruch 1, bei dem das Schaltungs-Mittel (6) ein Multiplexer ist.